# EUROPEAN PATENT SPECIFICATION

(11) **EP 2 975 921 B1**
(45) Date of publication and mention of the grant of the patent: **18.12.2019**
(21) Application number: 13878456.6
(22) Date of filing: 12.03.2013
(51) Int. Cl.: H05K 13/04, H05K 13/08

(54) **COMPONENT RECOGNITION SYSTEM FOR COMPONENT MOUNTING MACHINE**
KOMPONENTENERKENNUNGSSYSTEM FÜR EINE KOMPONENTENMONTAGEMASCHINE
SYSTÈME DE RECONNAISSANCE DE COMPOSANT POUR MACHINE DE MONTAGE DE COMPOSANT

(43) Date of publication of application: 20.01.2016
(73) Proprietor: FUJI Corporation, Chiryu Aichi (JP)
(72) Inventor: KOBAYASHI, Takahiro, Chiryu, Aichi (JP); OIKE, Hiroshi, Chiryu, Aichi (JP); ESAKI, Hirotake, Chiryu, Aichi (JP)
(74) Representative: Grünecker Patent- und Rechtsanwälte PartG mbB
(86) International application number: PCT/JP2013/056770
(87) International publication number: WO 2014/141380

(56) References cited:
- JP-A- H09 321 498
- JP-A- H11 220 298
- JP-A- 2001 060 800
- JP-A- 2001 060 800
- JP-A- 2008 066 608
- JP-A- 2008 294 065
- JP-A- 2009 094 295
- JP-A- 2009 264 862
- JP-A- 2014 154 750

## Description

### Technical Field

The present invention relates to a component recognizing system of a component mounting machine which includes a camera for imaging a component sucked by a suction nozzle from below.

### Background Art

In recent years, a component mounting machine has an image processing function in which a camera is caused to image a component sucked by a suction nozzle from below and an image thereof is processed so as to recognize a suction posture of the component or a misaligned suction position. However, height data cannot be acquired from a two-dimensional image of the component imaged by the camera. Consequently, it is not possible to inspect defects in a height direction (Z-direction), such as lead bending and the absence of bumps in the component.

Therefore, a component mounting machine disclosed in PTL 1 (Japanese Patent No. 3926347) adopts a configuration in which a three-dimensional measurement device using a laser beam for one-dimensional scanning is installed so as to face upward, a component sucked by a suction nozzle is moved above the three-dimensional measurement device at a constant speed, and a one-dimensional scanning process using the laser beam is repeatedly performed in a predetermined cycle in a direction perpendicular to a moving direction of the component. In this manner, a three-dimensional image of the component is captured, and lead bending of the component is inspected based on the three-dimensional image.

Related prior art disclosed in PTL 2 (Japanese Patent No. 4315536) proposed to provide an electronic parts-mounting method and device capable of reducing time required for inspecting a three-dimensional shape and of reducing mounting tact time. Light is applied to electronic parts by an LED illumination light source, thus obtaining two-dimensional data for positioning by picking up an image using a CCD camera. After the suction angle of the electronic parts is corrected, a laser diode is turned on and line light is projected to the terminal part of the electronic parts by a line generator lens. A light projection unit is moved by a linear motor, thus scanning the electronic parts with the line light. The projection light image of the line light is picked up by the CCD camera, and height data of the terminal from a light-cutting line by the line light is acquired, thus inspecting the flatness of the terminal part.

Both PTL 1 and PTL 2 disclose component recognizing systems according to the preamble of independent claim 1.

Meanwhile, PTL 3 (Japanese Patent No. 5055191) proposes to enhance the accuracy of measurement with a simple structure even if an object to be measured where surface regions having different reflectivities due to letters, patterns, etc., coexist, by a three-dimensional shape measuring method and its device using a phase shift method. This device includes two stripe pattern projection sections for projecting stripe patterns to a measurement region of an object to be measured, an imaging section, and a three-dimensional measurement processing section for finding a three-dimensional shape of the measurement region based on data from the imaging section.

### Citation List

### Patent Literature

PTL 1: Japanese Patent No. 3926347
PTL 2: Japanese Patent No. 4315536
PTL 3: Japanese Patent No. 5055191

### Summary of Invention

### Technical Problem

However, according to the method of capturing the three-dimensional image which is disclosed in PTL 1 described above, the one-dimensional scanning using the laser beam is repeatedly performed in the predetermined cycle so as to capture the three-dimensional image. Consequently, it is necessary to cause the component sucked by the suction nozzle to move slowly above the three-dimensional measurement device at a constant speed (low speed of approximately one-tenth of the maximum speed). In order to stabilize moving speed, it is necessary to cause the component to move at the low speed after the component is temporarily stopped in front of a scanning area above the three-dimensional measurement device. For this reason, a longer time is required in capturing the three-dimensional image. Moreover, in order to improve resolution (height measurement accuracy), it is necessary to slow down the moving speed of the component. Accordingly, a further lengthened amount of time is required in capturing the three-dimensional image, thereby inevitably causing a decline in productivity.

In addition, according to PTL 1 described above, positioning of the component is performed by extracting two-dimensional data related to a position of the component from three-dimensional image data captured by the one-dimensional scanning using the laser beam. Therefore, a configuration is adopted which does not need the camera for imaging the component sucked by the suction nozzle. However, since the lengthened time is required in capturing the image as described above, there is still an unresolved problem in that productivity declines.

Therefore, an object to be achieved by the invention is to provide a component recognizing system of a component mounting machine which can improve productivity by shortening an amount of time required for recognizing a three-dimensional shape of a component sucked by a suction nozzle.

### Solution to Problem

In order to achieve the above-described object, there is provided a component recognizing system according to independent claim 1. An embodiment disclosed herein is a component recognizing system of a component mounting machine which causes a suction nozzle to suck a component supplied from a component supply device so as to be mounted on a circuit board. The component recognizing system includes a camera that images the component sucked by the suction nozzle from below, a light pattern projecting device that projects a predetermined light pattern onto the component sucked by the suction nozzle in a direction different from an imaging direction of the camera, and a image processing device that processes an image captured by the camera. The image processing device is configured to have three-dimensional recognizing means which causes the light pattern projecting device to project the light pattern onto the component, processes the image captured by the camera, recognizes the light pattern on a surface of the component, and recognizes a three-dimensional shape (height) of the component when viewed from below.

According to this configuration, the component onto which the light pattern is projected is imaged by the camera, and the image is processed so as to recognize the three-dimensional shape of the component. Accordingly, it is not necessary to cause the component to move at a low speed within a visible range of the camera. In this manner, it is possible to shorten an amount of time required for recognizing the three-dimensional shape of the component sucked by the suction nozzle, and thus it is possible to improve productivity.

In this case, the light pattern projecting device which projects the light pattern in multiple directions different from the imaging direction of the camera may be disposed in multiple locations. According to this configuration, it is possible to project the light patterns onto the surface of the component having the three-dimensional shape in multiple directions. Therefore, it is possible to enlarge a surface area of the component onto which the light pattern is projected (it is possible to minimize a surface area of a shaded portion), and thus it is possible to improve accuracy in recognizing the three-dimensional shape.

The embodiment may be configured so that two-dimensional image data is extracted from three-dimensional image data as disclosed in PTL 1 described above. However, an amount of time required for capturing the three-dimensional image data is longer than an amount of time required for capturing the two-dimensional image data which is obtained by single imaging of the camera. In addition, among components to be mounted on a circuit board, there exists a component for which the three-dimensional shape does not need to be recognized (for example, components having a simple shape such as chip capacitors and chip resistors).

In view of these points, the image processing device may have two-dimensional recognizing means for processing the image captured by the camera in a state where the light pattern projecting device does not project the light pattern and for recognizing a two-dimensional shape of the component when viewed from below, and image recognizing mode switching means for switching between a two-dimensional recognizing mode using the two-dimensional recognizing means and a three-dimensional recognizing mode using the three-dimensional recognizing means. According to this configuration, in a case of the component having the simple shape for which the three-dimensional shape does not need to be recognized, it is possible to shorten the time required for capturing the image data by switching a mode over to the two-dimensional recognizing mode using the two-dimensional recognizing means, and thus it is possible to improve productivity.

In this case, when a mode is switched over to the two-dimensional recognizing mode by the image recognizing mode switching means, the image processing device may determine at least any one of a suction posture and a suction position of the component, and the presence or absence of the component, based on a recognized result of the two-dimensional recognizing means. When a mode is switched over to the three-dimensional recognizing mode by the image recognizing mode switching means, the image processing device may inspect at least any one of lead bending and the absence of bumps in the component, and oblique suction of the component, based on a recognized result of the three-dimensional recognizing means, and may also determine at least any one of the suction posture and the suction position of the component, and the presence or absence of the component.

In addition, the configuration according to the embodiment may further include component mounting correction means for performing at least one among correction of mounting height of the component, correction of component pressing force during mounting, and tilting correction of the component, based on the recognized result of the three-dimensional recognizing means. In this manner, it is possible to improve accuracy in component mounting.

In addition, the image processing device may cause the camera to capture an image of the light pattern by causing the light pattern projecting device to project the light pattern onto a lower end surface of the suction nozzle before the suction nozzle sucks the component, may recognize the three-dimensional shape of the lower end surface of the suction nozzle by processing the image and recognizing the light pattern projected onto the lower end surface of the suction nozzle, and may determine the absence of the suction nozzle, based on the recognized result. According to this configuration, it is also possible to determine the absence of the suction nozzle.

### Brief Description of Drawings

[Fig. 1] Fig. 1 is a plan view illustrating a configuration of a component recognizing system of a component mounting machine and the surrounding portions thereof according to an embodiment of the invention.
[Fig. 2] Fig. 2 is a perspective view schematically illustrating a configuration of the component recognizing system.
[Fig. 3] Fig. 3 is a block diagram illustrating a function of an image processing device.

### Description of Embodiments

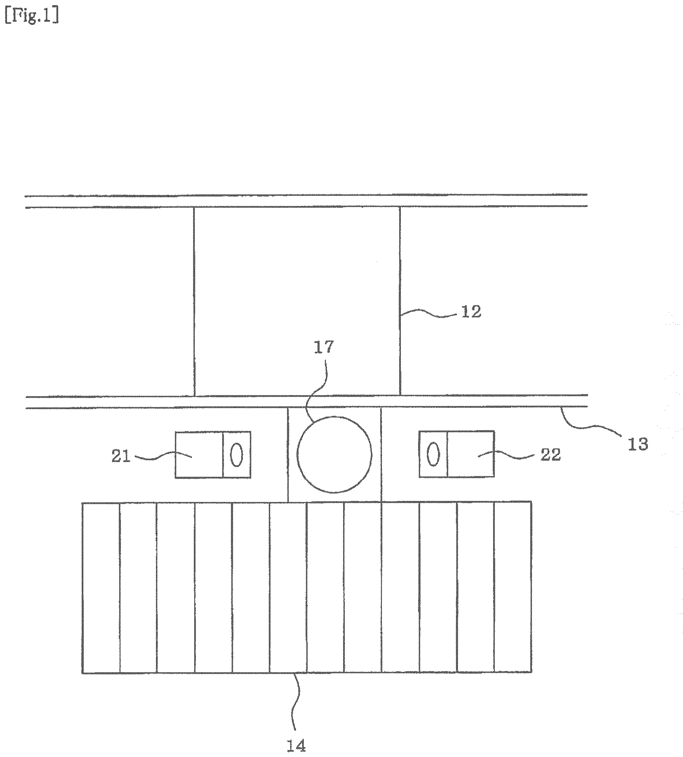

Hereinafter, an embodiment will be described in which an aspect of the invention is embodied. First, a configuration of a component recognizing system of a component mounting machine according to the present embodiment will be described with reference to Figs. 1 to 3.

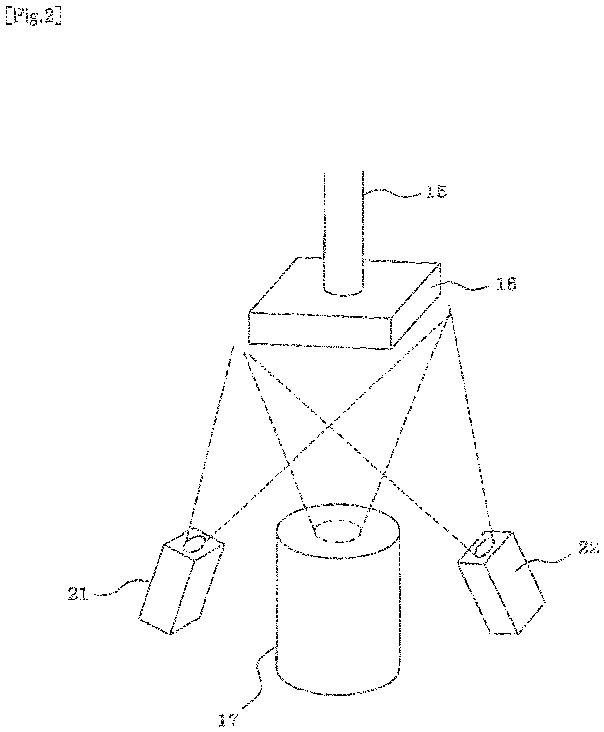

As illustrated in Fig. 1, the component mounting machine includes a conveyor 13 which conveys a circuit board 12, a component supply device 14 such as a tape feeder which supplies a component 16 (refer to Fig. 2), a mounting head (not illustrated) which holds a suction nozzle 15 (refer to Fig. 2) for sucking the component 16 supplied from the component supply device 14, and a head moving device (not illustrated) which causes the mounting head to perform XY-movement.

As illustrated in Fig. 2, a camera 17 by which the component 16 sucked by the suction nozzle 15 is imaged from below is arranged so as to face upward between the component supply device 14 and the conveyor 13. Two light pattern projecting devices 21 and 22 which project a predetermined light pattern to the component 16 sucked by the suction nozzle 15 in a direction different from the imaging direction (directly upward direction) of the camera 17 are installed on both sides of the camera 17.

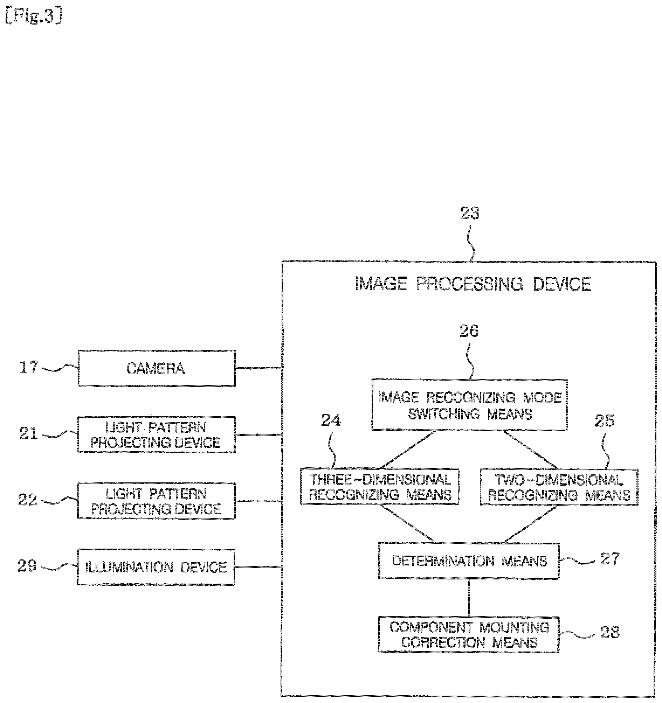

As illustrated in Fig. 3, a signal of the image captured by the camera 17 is incorporated into an image processing device 23. The image processing device 23 is configured to include three-dimensional recognizing means 24 for recognizing a three-dimensional shape (height) of the component 16 when viewed from below by causing the light pattern projecting devices 21 and 22 to project the light pattern to the component 16 stopped above the camera 17, by processing the image in which the component 16 is imaged by the camera 17, and by recognizing the light pattern on the surface of the component 16, two-dimensional recognizing means 25 for recognizing a two-dimensional shape of the component 16 when viewed from below by processing the image captured by the camera 17 in a state where the light pattern projecting devices 21 and 22 do not project the light pattern, and image recognizing mode switching means 26 for switching between a two-dimensional recognizing mode using the two-dimensional recognizing means 25 and a three-dimensional recognizing mode using the three-dimensional recognizing means 24.

When the two-dimensional recognizing means 25 recognizes the two-dimensional shape of the component 16, the light pattern projecting devices 21 and 22 do not need to project the light pattern. Accordingly, a general illumination device 29 which uniformly illuminates the entire body of the component 16 sucked by the suction nozzle 15 is disposed therein. The illumination device 29 uniformly illuminates the entire body of the component 16, thereby causing the camera 17 to image the component 16.

When the three-dimensional recognizing means 24 recognizes the three-dimensional shape of the component 16, the camera 17 images the component 16 while the light pattern projecting devices 21 and 22 project the light pattern. For example, as a recognizing method of the three-dimensional image, a phase shift method or a spatial encoding method may be used.

According to the phase shift method, the camera 17 images the component 16 several times by projecting a predetermined light pattern (pattern whose intensity is changed into a sine wave shape) to the component 16 in a direction different from the imaging direction of the camera 17 after changing a phase of the pattern, thereby synthesizing multiple acquired images and obtaining the three-dimensional image data.

According to the spatial encoding method, the camera 17 images the component 16 several times by projecting a predetermined light pattern (black and white bit pattern) to the component 16 in the direction different from the imaging direction of the camera 17 after finely changing pitches of the pattern, thereby synthesizing multiple acquired images and obtaining the three-dimensional image data.

Without being limited to the phase sift method and the spatial encoding method, as the recognizing method of the three-dimensional image, the other pattern projecting methods (grid pattern projecting method, moire method, interferometry, and the like) may be used. According to the grid pattern projecting method, a stripe pattern is projected to the component 16 so as to capture an image. According to the moire method, grid patterns are respectively arranged in the light pattern projecting devices 21 and 22 and the camera 17, and a moire pattern is observed so as to measure the depth. According to the interferometry, interference fringes generated by causing reflected light and reference light to interfere with each other are observed so as to measure the depth.

In addition, the image processing device 23 is configured to include determination means 27 and component mounting correction means 28. The determination means 27 determines at least one among a suction posture and a suction position of the component 16, and the presence or absence of the component 16, based on a recognized result of the two-dimensional recognizing means 25, when a mode is switched over to the two-dimensional recognizing mode by the image recognizing mode switching means 26, inspects at least any one among lead bending and the absence of bumps in the component 16, and oblique suction of the component 16, based on a recognized result of the three-dimensional recognizing means 24, and determines at least any one of the suction posture and the suction position of the component 16, and the presence or absence of the component 16, when a mode is switched over to the three-dimensional recognizing mode by the image recognizing mode switching means 26. The component mounting correction means 28 performs at least one among correction of mounting height of the component 16, correction of a component pressing force during mounting, and tilting correction of the component 16, based on the recognized result of the three-dimensional recognizing means 24.

The image processing device 23 also includes a function in which the camera 17 captures an image of the light pattern by causing the light pattern projecting devices 21 and 22 to project the light pattern onto a lower end surface of the suction nozzle 15 before the suction nozzle 15 sucks the component 16, the three-dimensional shape of the lower end surface of the suction nozzle 15 is recognized by processing the image and recognizing the light pattern projected onto the lower end surface of the suction nozzle 15, and the absence of the suction nozzle 15 is determined based on the recognized result.

According to the present embodiment described above, the light pattern is projected to the component 16 stopped above the camera 17, and the image obtained by the camera 17 imaging the component 16 is processed so as to recognize the three-dimensional shape of the component 16. Accordingly, it is not necessary to cause the component to move slowly in the field of view of the camera 17. In this manner, it is possible to shorten an amount of time required for recognizing the three-dimensional shape (height) of the component 16 sucked by the suction nozzle 15, and thus it is possible to improve productivity.

Moreover, according to the present embodiment, the light pattern is projected to the component 16 in multiple directions different from the imaging direction of the camera 17. Therefore, it is possible to enlarge a surface area of the portion to which the light pattern is projected (it is possible to minimize a surface area of a shaded portion), and thus it is possible to improve accuracy in recognizing the three-dimensional shape.

As disclosed above in PTL 1, the invention may be configured so that two-dimensional image data is extracted from three-dimensional image data. However, an amount of time required for capturing the three-dimensional image data is longer than an amount of time required for capturing the two-dimensional image data which is obtained by single imaging of the camera 17. In addition, among components to be mounted on the circuit board 12, there exists a component for which the three-dimensional shape does not need to be recognized (for example, components having a simple shape such as chip capacitors and chip resistors).

In view of these points, in addition to the three-dimensional recognizing means 24, the present embodiment is configured to include the two-dimensional recognizing means 25 for processing the image captured by the camera 17 in a state where the light pattern projecting devices 21 and 22 do not project the light pattern and for recognizing the two-dimensional shape of the component 16 when viewed from below, and image recognizing mode switching means 26 for switching between the two-dimensional recognizing mode using the two-dimensional recognizing means 25 and the three-dimensional recognizing mode using the three-dimensional recognizing means 24. According to this configuration, in a case of the component having the simple shape for which the three-dimensional shape does not need to be recognized, it is possible to shorten the amount of time required for capturing the image data by switching a mode over to the two-dimensional recognizing mode using the two-dimensional recognizing means 25, and thus it is possible to improve productivity. In this case, a recognizing mode for every component may be preset in component data having recorded data relating to a component shape and a recognizing method, or recorded data relating to a conveyance method.

In addition, the present embodiment is configured to include the component mounting correction means 28 which performs at least one among correction of mounting height of the component 16, correction of a component pressing force during mounting, and tilting correction of the component 16, based on the recognized result of the three-dimensional recognizing means 24. Accordingly, it is possible to improve accuracy in component mounting.

According to the present embodiment, when the two-dimensional recognizing means 25 recognizes the two-dimensional shape of the component 16, the light pattern projecting devices 21 and 22 do not project the light pattern, and the illumination device 29 illuminates the entire body of the component 16 so as to be imaged by the camera 17. Even when the two-dimensional shape of the component 16 is recognized, a configuration may be adopted in which the camera 17 images the component 16 so as to recognize the two-dimensional shape of the component 16 from the captured image while the light pattern projecting devices 21 and 22 project the light pattern. The reason is that the two-dimensional shape (outer shape of the component) can also be recognized by using an image for recognizing the three-dimensional shape.

Alternatively, without being limited to the present embodiment, the light pattern projecting device may be arranged at three or more locations around the camera 17, or the position of the camera 17 may be changed. Therefore, the present invention is defined by the appended claims.

### Reference Signs List

12 ... CIRCUIT BOARD, 13 ... CONVEYOR, 14 ... COMPONENT SUPPLY DEVICE, 15 ... SUCTION NOZZLE, 16 ... COMPONENT, 17 ... CAMERA, 21, 22 ... LIGHT PATTERN PROJECTING DEVICE, 23 ... IMAGE PROCESSING DEVICE, 24 ... THREE-DIMENSIONAL RECOGNIZING MEANS, 25 ... TWO-DIMENSIONAL RECOGNIZING MEANS, 26 ... IMAGE RECOGNIZING MODE SWITCHING MEANS, 27 ... DETERMINATION MEANS, 28 ... COMPONENT MOUNTING CORRECTION MEANS, 29 ... ILLUMINATION DEVICE

## Claims

1. A component recognizing system of a component mounting machine which is configured to cause a suction nozzle (15) to suck a component (16) supplied from a component supply device (14) so as to be mounted on a circuit board (12), comprising:
a camera (17) that is configured to image the component (16) sucked by the suction nozzle (15) from below;
a image processing device (23) that is configured to process an image captured by the camera (17); and
a light pattern projecting device (21, 22) that is configured to project a predetermined light pattern onto the component (16) sucked by the suction nozzle (15) in a direction different from an imaging direction of the camera (17),
wherein the image processing device (23) has three-dimensional recognizing means (24) which is configured to cause the light pattern projecting device (21, 22) to project the light pattern onto the component (16), process the image captured by the camera (17), recognize the light pattern on a surface of the component (16), and recognize a three-dimensional shape of the component (16) when viewed from below,
**characterized in that**
the image processing device (23) has two-dimensional recognizing means (25) for processing the image captured by the camera (17) in a state where the light pattern projecting device (21, 22) does not project the light pattern and for recognizing a two-dimensional shape of the component (16) when viewed from below, and image recognizing mode switching means (27) for switching between a two-dimensional recognizing mode using the two-dimensional recognizing means (25) and a three-dimensional recognizing mode using the three-dimensional recognizing means (24).

2. The component recognizing system of a component mounting machine according to Claim 1,
wherein the light pattern projecting device (21, 22) which is configured to project the light pattern in multiple directions different from the imaging direction of the camera (17) is disposed in multiple locations.

3. The component recognizing system of a component mounting machine according to Claim 1 or 2,
configured such that when a mode is switched over to the two-dimensional recognizing mode by the image recognizing mode switching means (27), the image processing device (23) is configured to determine at least any one of a suction posture and a suction position of the component (16), and the presence or absence of the component (16), based on a recognized result of the two-dimensional recognizing means (25), and
such that when a mode is switched over to the three-dimensional recognizing mode by the image recognizing mode switching means (27), the image processing device (23) is configured to inspect at least any one of lead bending and the absence of bumps in the component (16), and oblique suction of the component (16), based on a recognized result of the three-dimensional recognizing means (24), and also determine at least any one of the suction posture and the suction position of the component (16), and the presence or absence of the component (16).

4. The component recognizing system of a component mounting machine according to any one of Claims 1 to 3, further comprising:
component mounting correction means (28) for performing at least one among correction of mounting height of the component (16), correction of component pressing force during mounting, and tilting correction of the component (16), based on the recognized result of the three-dimensional recognizing means (24).

5. The component recognizing system of a component mounting machine according to any one of Claims 1 to 4,
wherein the image processing device (23) is configured to cause the camera (17) to capture an image of the light pattern by causing the light pattern projecting device (21, 22) to project the light pattern onto a lower end surface of the suction nozzle (15) before the suction nozzle (15) sucks the component (16), recognize the three-dimensional shape of the lower end surface of the suction nozzle (15) by processing the image and recognizing the light pattern projected onto the lower end surface of the suction nozzle (15), and determine the absence of the suction nozzle (15), based on the recognized result.

## Patentansprüche

1. System zum Erkennen von Bauteilen einer Maschine zum Montieren von Bauteilen, das so eingerichtet ist, dass es eine Saugdüse (15) veranlasst, ein von einer Bauteil-Zuführvorrichtung (14) zugeführtes Bauteil (16) anzusaugen, um es auf einer Leiterplatte (12) zu montieren, wobei es umfasst:
eine Kamera (17), die so eingerichtet ist, dass sie ein Bild des durch die Saugdüse (15) angesaugten Bauteils (16) von unten erzeugt;
eine Bild-Verarbeitungsvorrichtung (23), die so eingerichtet ist, dass sie ein von der Kamera (17) aufgenommenes Bild verarbeitet; sowie
eine Vorrichtung (21, 22) zum Projizieren eines Lichtmusters, die so eingerichtet ist, dass sie ein vorgegebenes Lichtmuster auf das von der Saugdüse (15) angesaugte Bauteil (16) in einer Richtung projiziert, die sich von einer Bilderzeugungs-Richtung der Kamera (17) unterscheidet,
wobei die Bild-Verarbeitungsvorrichtung (23) eine 3D-Erkennungseinrichtung (24) aufweist, die so eingerichtet ist, dass sie die Vorrichtung (21, 22) zum Projizieren eines Lichtmusters veranlasst, das Lichtmuster auf das Bauteil (16) zu projizieren, das von der Kamera (17) aufgenommene Bild verarbeitet, das Lichtmuster an einer Oberfläche des Bauteils (16) erkennt und eine dreidimensionale Form des Bauteils (16) bei Betrachtung von unten erkennt,
**dadurch gekennzeichnet, dass**
die Bild-Verarbeitungsvorrichtung (23) eine 2D-Erkennungseinrichtung (25), mit der das Bild verarbeitet wird, das von der Kamera (17) in einem Zustand aufgenommen wird, in dem die Vorrichtung (21, 22) zum Projizieren eines Lichtmusters das Lichtmuster nicht projiziert, und eine zweidimensionale Form des Bauteils (16) bei Betrachtung von unten erkannt wird, sowie eine Einrichtung (27) zum Umschalten eines Erkennungs-Modus aufweist, mit der zwischen einem 2D-Erkennungs-Modus, bei dem die 2-D-Erkennungseinrichtung (25) eingesetzt wird, und einem 3D-Erkennungs-Modus umgeschaltet wird, bei dem die 3D-Erkennungseinrichtung (24) eingesetzt wird.

2. System zum Erkennen von Bauteilen einer Maschine zum Montieren von Bauteilen nach Anspruch 1,
wobei die Vorrichtung (21, 22) zum Projizieren eines Lichtmusters, die so eingerichtet ist, dass sie das Lichtmuster in mehreren Richtungen projiziert, die sich von der Bilderzeugungs-Richtung der Kamera (17) unterscheiden, an mehreren Stellen angeordnet ist.

3. System zum Erkennen von Bauteilen einer Maschine zum Montieren von Bauteilen nach Anspruch 1 oder 2,
das so eingerichtet ist, dass die Bild-Verarbeitungsvorrichtung (23) so eingerichtet ist, dass sie, wenn durch die Einrichtung (27) zum Umschalten eines Erkennungs-Modus auf den 2D-Erkennungs-Modus umgeschaltet wird, eine Ansaug-Stellung oder/und eine Ansaug-Position des Bauteils (16) sowie das Vorhandensein oder Nichtvorhandensein des Bauteils (16) auf Basis eines Erkennungsergebnisses der 2D-Erkennungseinrichtung (25) bestimmt, und
so dass, die Bild-Bearbeitungsvorrichtung (23) so eingerichtet ist, dass sie, wenn ein Modus durch die Einrichtung (27) zum Umschalten eines Erkennungs-Modus auf den 3D-Erkennungs-Modus umgeschaltet wird, auf Basis des Erkennungsergebnisses der 3D- Erkennungseinrichtung (24) auf Verbiegung von Zuleitungen sowie das Nichtvorhandensein von Bumps oder/und schräges Ansaugen des Bauteils prüft und darüber hinaus die Ansaug-Stellung oder/und die Ansaug-Position des Bauteils (16) sowie das Vorhandensein oder Nichtvorhandensein des Bauteils (16) bestimmt.

4. System zum Erkennen von Bauteilen einer Maschine zum Montieren von Bauteilen nach einem der Ansprüche 1 bis 3, das des Weiteren umfasst:
eine Einrichtung (28) zur Korrektur von Bauteil-Montage, mit der wenigstens Korrektur der Montage-Höhe des Bauteils (16), Korrektur der Bauteil-Presskraft beim Montieren oder Neigungs-Korrektur des Bauteils (16) auf Basis des Erkennungsergebnisses der 3D-Erkennungseinrichtung (24) durchgeführt wird.

5. System zum Erkennen von Bauteilen einer Maschine zum Montieren von Bauteilen nach einem der Ansprüche 1 bis 4,
wobei die Bild-Verarbeitungsvorrichtung (23) so eingerichtet ist, dass sie die Kamera (17) veranlasst, ein Bild des Lichtmusters aufzunehmen, indem sie die Vorrichtung (21, 22) zum Projizieren eines Lichtmusters veranlasst, das Lichtmuster auf eine untere Endfläche der Saugdüse (15) zu projizieren, bevor die Saugdüse (15) das Bauteil (16) ansaugt, die dreidimensionale Form der unteren Endfläche der Saugdüse (15) erkennt, indem sie das Bild verarbeitet und das auf die untere Endfläche der Saugdüse (15) projizierte Lichtmuster erkennt, und das Vorhandensein der Saugdüse (15) auf Basis des Erkennungsergebnisses bestimmt.

## Revendications

1. Système de reconnaissance de composant d'une machine de montage de composant qui est configuré pour amener une buse d'aspiration (15) à aspirer un composant (16) alimenté par un dispositif d'alimentation en composants (14) de manière à être monté sur une carte de circuit imprimé (12), comprenant :
un dispositif de prise de vue (17) qui est configuré pour représenter le composant (16) aspiré par la buse d'aspiration (15) par le dessous ;
un dispositif de traitement d'image (23) qui est configuré pour traiter une image capturée par le dispositif de prise de vue (17) ; et
un dispositif de projection de motif lumineux (21, 22) qui est configuré pour projeter un motif lumineux prédéterminé sur le composant (16) aspiré par la buse d'aspiration (15) dans une direction différente d'une direction d'imagerie du dispositif de prise de vue (17),
dans lequel le dispositif de traitement d'image (23) comporte des moyens de reconnaissance tridimensionnelle (24) qui sont configurés pour amener le dispositif de projection de motif lumineux (21, 22) à projeter le motif lumineux sur le composant (16), traiter l'image capturée par le dispositif de prise de vue (17), reconnaître le motif lumineux sur une surface du composant (16), et reconnaître une forme tridimensionnelle du composant (16) lorsqu'observé de dessous,
**caractérisé en ce que**
le dispositif de traitement d'image (23) comporte des moyens de reconnaissance bidimensionnelle (25) pour traiter l'image capturée par la dispositif de prise de vue (17) dans un état où le dispositif de projection de motif lumineux (21, 22) ne projette pas le motif lumineux et pour reconnaître une forme bidimensionnelle du composant (16) lorsqu'observé de dessous, et des moyens de commutation de mode de reconnaissance d'image (27) pour commuter entre un mode de reconnaissance bidimensionnelle utilisant les moyens de reconnaissance bidimensionnelle (25) et un mode de reconnaissance tridimensionnelle utilisant les moyens de reconnaissance tridimensionnelle (24).

2. Système de reconnaissance de composant d'une machine de montage de composant selon la revendication 1,
dans lequel le dispositif de projection de motif lumineux (21, 22) qui est configuré pour projeter le motif lumineux dans de multiples directions différentes de la direction d'imagerie du dispositif de prise de vue (17) est disposé à de multiples endroits.

3. Système de reconnaissance de composant d'une machine de montage de composant selon la revendication 1 ou 2,
configuré de telle sorte que lorsqu'un mode est commuté en le mode de reconnaissance bidimensionnelle par les moyens de commutation de mode de reconnaissance d'image (27), le dispositif de traitement d'image (23) est configuré pour déterminer au moins l'une quelconque parmi une posture d'aspiration et une position d'aspiration du composant (16), et la présence ou l'absence du composant (16), sur la base d'un résultat reconnu des moyens de reconnaissance bidimensionnelle (25), et
de telle sorte que lorsqu'un mode est commuté en le mode de reconnaissance tridimensionnelle par les moyens de commutation de mode de reconnaissance d'image (27), le dispositif de traitement d'image (23) est configuré pour inspecter au moins l'une quelconque parmi une courbure de pattes et l'absence de bosses dans le composant (16), et une aspiration oblique du composant (16), sur la base d'un résultat reconnu des moyens de reconnaissance tridimensionnelle (24), et déterminer également au moins l'une quelconque parmi la posture d'aspiration et la position d'aspiration du composant (16), et la présence ou l'absence du composant (16).

4. Système de reconnaissance de composant d'une machine de montage de composant selon l'une quelconque des revendications 1 à 3, comprenant en outre :
des moyens de correction de montage de composant (28) pour effectuer au moins une correction parmi une correction de hauteur de montage du composant (16), une correction de force de pression de composant pendant le montage, et une correction d'inclinaison du composant (16), sur la base du résultat reconnu des moyens de reconnaissance tridimensionnelle (24).

5. Système de reconnaissance de composant d'une machine de montage de composant selon l'une quelconque des revendications 1 à 4,
dans lequel le dispositif de traitement d'image (23) est configuré pour amener le dispositif de prise de vue (17) à capturer une image du motif lumineux en amenant le dispositif de projection de motif lumineux (21, 22) à projeter le motif lumineux sur une surface d'extrémité inférieure de la buse d'aspiration (15) avant que la buse d'aspiration (15) n'aspire le composant (16), reconnaître la forme tridimensionnelle de la surface d'extrémité inférieure de la buse d'aspiration (15) en traitant l'image et en reconnaissant le motif lumineux projeté sur la surface d'extrémité inférieure de la buse d'aspiration (15), et déterminer l'absence de la buse d'aspiration (15), sur la base du résultat reconnu.
